Europäisches Patentamt

European Patent Office

Office européen des brevets

(11) Veröffentlichungsnummer: **0 239 844 B1**

# EUROPÄISCHE PATENTSCHRIFT

(45) Veröffentlichungstag der Patentschrift: **10.06.92**

(51) Int. Cl.⁵: **H03K 5/08**, H04L 5/26

(21) Anmeldenummer: **87103506.9**

(22) Anmeldetag: **11.03.87**

(54) **Schaltungsanordnung zur Zeitregeneration von Breitband-Digitalsignalen.**

(30) Priorität: **14.03.86 DE 3608601**

(43) Veröffentlichungstag der Anmeldung:
**07.10.87 Patentblatt 87/41**

(45) Bekanntmachung des Hinweises auf die
Patenterteilung:
**10.06.92 Patentblatt 92/24**

(84) Benannte Vertragsstaaten:
**AT BE CH DE FR GB IT LI NL SE**

(56) Entgegenhaltungen:
EP-A- 0 243 634      DE-A- 2 324 692
DE-A- 3 346 725      US-A- 3 243 604
US-A- 3 537 025      US-A- 4 263 555
US-A- 4 464 587

PATENT ABSTRACTS OF JAPAN, Band 10,
Nr. 205 (E-420)[2261], 17. Juli 1986; & JP-A-61
48 232

PATENT ABSTRACTS OF JAPAN, Band 8,
Nr.84 (E-239)(1521), 18.April 1984; & JP-
A-59005740

IBM TECHNICAL DISCLOSURE BULLETIN,
Band 11, Nr. 10, März 1969, Seiten 1272, 1273

(73) Patentinhaber: **SIEMENS AKTIENGESELL-
SCHAFT**
**Wittelsbacherplatz 2**
**W-8000 München 2(DE)**

(72) Erfinder: **Trumpp, Gerhard, Dipl.-Ing.**
**Mitterlängstrasse 7**
**W-8039 Puchheim(DE)**

## Beschreibung

In Breitband-Digitalsignal-Vermittlungs- u./o. Übertragungssystemen setzen Laufzeiteffekte dem zeitlichen Auflösungsvermögen des Vermittlungs- u./o. Übertragungssystems und damit der maximal zulässigen Bitrate eine Grenze, die indessen durch - ggf. in kurzen räumlichen Abständen wiederholte - Zeitregeneration der Breitband-Digitalsignale nach oben verschiebbar ist (DE-A 28 36 695; Pfannschmidt: "Arbeitsgeschwindigkeitsgrenzen von Zeitvielfach-Raumkoppelnetzwerken für Breitband-Digitalsignale", Diss. Braunschweig 1978, inbes.S. 78). Dabei rühren solche Laufzeiteffekte nicht nur von den sich innerhalb des Vermittlungs- u./o. Übertragungssystems addierenden, nicht mehr vernachlässigbar kleinen Laufzeiten als solchen und von Laufzeitstreuungen integrierter Schaltkreise sowie davon her, daß durch Übersprecherscheinungen Signalflanken eine Verschiebung erfahren; die zeitliche Auflösung wird vielmehr auch dadurch be-einträchtigt, daß insbesondere aktive Schaltungs-elemente für Signalflanken unterschiedlichen Vor-zeichens unterschiedliche Laufzeiten aufweisen. Letzterem durch eine nur wenig aufwendige Zeitregeneration zu begegnen, zeigt nun die von einer Codierung der Breitband-Digitalsignale in einem gleichstromfreien Code ausgehende Erfindung einen Weg.

Bei einer (aus JP-A-59-5740) bekannten, sicherlich auch zur Zeitregeneration von Digitalsignalen geeigneten Schaltungsanordnung mit einer Korrekturschaltung und einer zugehörigen, eine Tiefpaßschaltung enthaltenden Steuerschaltung ist in den Signalweg ein einen Digitalsignaleingang und einen Steuereingang aufweisendes Korrekturglied in Form eines Operationsverstärkers eingefügt, in dem das Digitalsignal nach Maßgabe der im Digitalsignal auftretenden Gleichstromkomponente an seinen Signalflanken des jeweils einen Vorzeichens eine erhöhte Laufzeit und zugleich an seinen Signalflanken des jeweils anderen Vorzeichens eine verringerte Laufzeit erfahren kann und zu dessen Steuereingang eine eine entsprechende Gleichstromkomponente ermittelnde Steuerschaltung mit einer vom Digitalsignal beaufschlagten Begrenzerschaltung (Operationsverstärker) und einer ihr nachgeschalteten Tiefpaßschaltung führt. Diese bekannte Impulsformerschaltung ist mit zwei Opera-tionsverstärkern (Komparator und Gleichstromver-stärker) realisiert; demgegenüber zeigt die Erfindung einen Weg zu einer nur wenig aufwendigen Zeitregeneration.

Die Erfindung betrifft eine zur Zeitregeneration von Digitalsignalen geeignete Schaltungsanordnung mit einer Korrekturschaltung und einer zugehöri-gen, eine Tiefpaßschaltung enthaltenden Steuer-schaltung, wobei in den Signalweg ein einen Digi-talsignaleingang und einen Steuereingang aufweis-endes Korrekturglied, in dem das Digitalsignal nach Maßgabe der im Digitalsignal auftretenden Gleichstromkomponente an seinen Signalflanken des jeweils einen Vorzeichens eine erhöhte Laufzeit und zugleich an seinen Signalflanken des jeweils anderen Vorzeichens eine verringerte Laufzeit erfahren kann, eingefügt ist, zu dessen Steuereingang eine eine entsprechende Gleichstromkomponente ermittelnde Steuerschaltung mit einer vom Digitalsignal beaufschlagten Begrenzerschaltung und einer ihr nachgeschalteten Tiefpaßschaltung führt; diese Schaltungsanordnung ist erfindungsgemäß zunächst einmal dadurch gekennzeichnet, daß zur Zeitregeneration von in einem gleichstromfreien Code codierten Breitband-Digitalsignalen in Breitband-Digitalsignal-Vermittlungs- u./o. Übertragungssystemen in dem Korrekturglied das Digitals-gnal nach Maßgabe **jeder** im Digitalsignal auftre-tenden Gleichstromkomponente an seinen Signal-flanken des jeweils einen Vorzeichens eine erhöhte Laufzeit und zugleich an seinen Signalflanken des jeweils anderen Vorzeichens eine verringerte Laufzeit erfährt.

Eine solche Schaltungsanordnung gemäß der Erfindung ist dann außerdem dadurch gekennzeichnet, daß das Korrekturglied mit einer eine von der Steu-erschaltung gesteuerte Schaltschwelle aufweisen-den Schwellwertschaltung gebildet ist, in der in den Digitalsignalweg ein mit einem Lasttransistor ver-bundener Schalttransistor in Gateschaltung einge-fügt ist, zu dessen Gate-Elektrode die steuerschaltung führt.

Eine andere solche Schaltungsanordnung gemäß der Erfindung ist dann außerdem dadurch gekennzeichnet, daß die mit einer Inverterschaltung gebildete Begrenzerschaltung und das Korrekturglied im Digitalsignalweg eine einzige Schaltungsstufe bilden, in der bei einer in C-MOS-Technik realisierten Inverterschaltung zwischen den MOS-Transistor des einen Kanaltyps und die zugehörige Speisepotentialquelle ein an seiner Steuerelektrode von der Tiefpaßschaltung her gesteuerter weiterer MOS-Transistor ebenfalls des einen Kanaltyps und zwischen den MOS-Transistor des anderen Kanaltyps und die zugehörige Speisepotentialquelle ein an seiner Steuerelektrode von der Tiefpaßschaltung her gesteuerter weiterer MOS-Transistor ebenfalls des anderen Kanaltyps eingefügt ist.

Eine weitere solche Schaltungsanordnung gemäß der Erfindung ist dann außerdem dadurch gekennzeichnet, daß die mit einer Inverterschaltung gebildete Begrenzerschaltung und das Korrekturglied im Digitalsignalweg eine einzige Schaltungsstufe bilden, in der eine in den Signalweg eingefügte Inverterschaltung eingangsseitig kapazitiv mit dem zugeführten, zeitlich zu regenerierenden Digitalsignal und zugleich galvanisch mit einer Schaltschwellen-Steuerspannung von einer Tiefpaßschaltung her beaufschlagt wird, die ihrerseits mit dem invertierten, zeitregenerierten Digitalsignal beaufschlagt ist.

Die Erfindung, die sich den Umstand zunutze macht, daß durch entsprechende Codierung üblicherweise eine Gleichstromfreiheit des zu übertragenden Digitalsignals angestrebt wird, bringt den Vorteil einer nur wenig aufwendigen und zugleich recht wirkungsvollen Korrektur von Laufzeitunterschieden der Digitalsignal-Flanken unterschiedlichen Vorzeichens mit sich - wobei die Verschiebung der Schaltschwelle in Verbindung mit der endlichen Flankensteilheit des Breitband-Digitalsignals die gewünschte Zeitregeneration bewirkt - und verringert damit den Bedarf an sonst erforderlichen aufwendigeren Zeitregeneratoren.

Einen solchen höheren Aufwand erfordert übrigens auch die (aus DE-A 33 46 725) bekannte Kompensation von Änderungen des Tastverhältnisses eines phasendemodulierten Datensignals, derzufolge das mittels einer Hochpaßfilterung gleichstromentkoppelte Datensignal durch einen Komparator regeneriert wird, an dessen einem Eingang eine feste Referenzspannung liegt und dessen anderem Eingang ein Summensignal aus dem phasendemodulierten Datensignal und einem dessen Gleichstrommittelwerte konstanthaltenden Zusatzsignal zugeführt wird, welches in einer Kompensationsschaltung aus dem das kompensierte Datensignal bildenden Ausgangssignal des Komparators durch Tiefpaßfilterung, Integration und Invertierung abgeleitet wird.

An dieser Stelle sei auch erwähnt, daß es im Zusammenhang mit einer Abtastung von graphischen Vorlagen und Umsetzung des Abtastsignals in ein Digitalsignal bekannt ist, zu einer von Variationen eines Hintergrundsignals und/oder von Eingangssignalimpulsamplitude u./o. -dauer unabhängigen Signaldetektion von im Hintergrundsignal enthaltenen kleinen Eingangssignalimpulsen im Signalweg eine Differenzschaltung und einen ihr nachfolgenden, hochverstärkenden Komparator vorzusehen, dessen Ausgang über einen einen Begrenzer, eine Mittelwertschaltung und eine mit ihrem zweiten Eingang an einer Referenzspannungsquelle liegende weitere Differenzschaltung aufweisenden Gegenkopplungspfad mit dem zweiten Eingang der erstgenannten Differenzschaltung verbunden ist (US-A 42 63 555); nähere Berührungspunkte mit der vorliegenden Erfindung sind nicht gegeben.

Schließlich sei bemerkt, daß ein Schalttransistor in Gateschaltung, dessen Gate-Elektrode von einer Steuerschaltung angesteuert wird, an sich (z.B. aus IBM Techn. Discl.Bull. 11(1969)10, 1272-1273 als Bestandteil eines Bipolar-MOSFET-Pegelkonverters) bekannt ist.

Hingewiesen sei an dieser Stelle auch noch auf die Zeitranggleiche EP-Patentanmeldung EP-A-0 243 634, die sich auf eine zur Ansteuerung eines IC-Bausteins durch ein Ausgangs-Digitalsignal eines anderen IC-Bausteins geeignete Schaltungsanordnung mit einer Eingangsschaltung, deren jeweilige Schaltschwelle, von einer Steuerschaltung mit einer von einem Digitalsignal beaufschlagten Begrenzerschaltung und einer ihr nachgeschalteten, zu dem Steuereingang der Eingangsschaltung führenden Tiefpaßschaltung gesteuert, nach Maßgabe der in dem Digitalsignal auftretenden Gleichstromkomponente eingestellt wird, bezieht, bei der zur Ansteuerung des IC-Bausteins durch eine Mehrzahl solcher Digitalsignale für die einzelnen Digitalsignale eine entsprechende Mehrzahl untereinander gleichartiger Eingangsschaltungen vorgesehen ist, die jeweils mit einem in den Digitalsignalweg eingefügten, mit einem Lasttransistor verbundenen Schalttransistor in Gateschaltung gebildet sind, zu dessen Gate-Elektrode eine gemeinsame Steuerschaltung führt, deren Begrenzerschaltung von einem in seinem Signalpegel auch für die übrigen Digitalsignale repräsentativen Digitalsignal beaufschlagt ist.

Um nun auf die Erfindung zurückzukommen, so kann in weiterer Ausgestaltung der Erfindung die Begrenzerschaltung dem Korrekturglied im Digitalsignalweg vorgeschaltet sein; alternativ zu einer solchen Ausbildung der Schaltungsanordnung gemäß der Erfindung als eine Steueranordnung ist es aber auch möglich, die Schaltungsanordnung gemäß der Erfindung als eine Regelanordnung auszubilden, in der die Begrenzerschaltung dem Korrekturglied im Digitalsignalweg nachgeschaltet ist oder in der Begrenzerschaltung und Korrekturglied im Digitalsignalweg eine einzige Schaltungsstufe bilden. In der Steuerschaltung mag als Tiefpaßschaltung vielfach ein RC-Glied genügen.

In weiterer Ausgestaltung der Erfindung kann die Tiefpaßschaltung über einen Regelverstärker mit dem Steuereingang der Korrekturschaltung verbunden sein, wobei der Regelverstärker je nach Anforderung auf eine P- oder eine PI-Regelungscharakteristik hin ausgelegt sein kann.

Weitere Besonderheiten der Erfindung werden aus der nachfolgenden näheren Erläuterung der Erfindung anhand der Zeichnungen ersichtlich. Dabei zeigen

FIG 1 schematisch ein Ausführungsbeispiel einer Steuer-Schaltungsanordnung gemäß der Erfindung und

FIG 2 schematisch ein Ausführungsbeispiel einer Regel-Schaltungsanordnung gemäß der Erfindung;

FIG 3 und FIG 4 zeigen Ausführungsbeispiele von Regel-Schaltungsanordnungen gemäß der Erfindung in ihren schaltungstechnischen Einzelheiten.

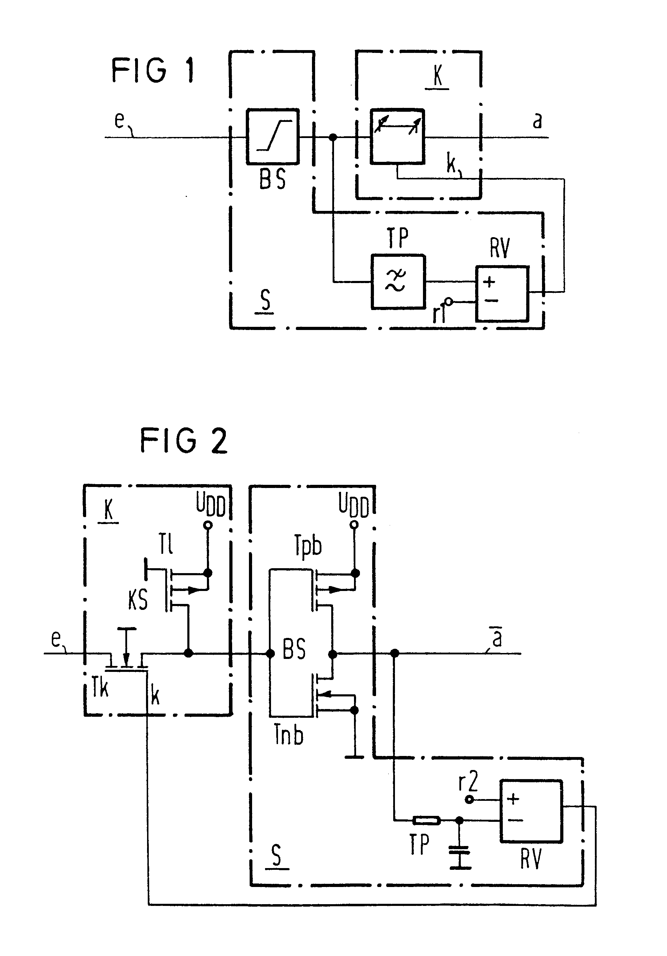

Das in FIG 1 schematisch dargestellte Ausführungsbeispiel einer Schaltungsanordnung zur Zeitregeneration von Breitband-Digitalsignalen gemäß der Erfindung weist eine in einen vom Breitband-Digitalsignal durchlaufenen Signalweg e - a eingefügte Korrekturschaltung K auf, der im Signalweg e - a die Begrenzerschaltung BS einer Steuerschaltung S vorgeschaltet ist, die ausserdem eine der vom Digitalsignal beaufschlagten Begrenzerschaltung BS nachgeschaltete, zum Steuereingang k der Korrekturschaltung K führende Tiefpaßschaltung TP aufweist; zwischen Tiefpaßschaltung TP und Korrekturschaltungseingang k ist im Ausführungsbeispiel gemäß FIG 1 ein Regelverstärker RV mit Differenzeingängen +, - eingefügt, dessen zweiter Eingang (-) mit einem Referenzsignal r1 beaufschlagt sein möge.

Aufgrund einer Codierung des Breitband-Digitalsignals in einem gleichstromfreien Code treten im Breitband-Digitalsignal, statistisch (d.h. über eine hinreichend lange Zeit) gesehen, die beiden Signalzustände "High" und "Low" gleich lange auf. Dies macht sich die Schaltungsanordnung gemäß der Erfindung zunutze, um durch unterschiedliche Laufzeiten von Digitalsignalflanken unterschiedlichen Vorzeichens bedingte Signalverzerrungen zumindest teilweise zu eliminieren: Weicht das Tastverhältnis des am Signalweg-Eingang e auftretenden Breitband-Digitalsignals bzw., genauer gesagt, des in der Begrenzerschaltung BS amplitudenbegrenzten Digitalsignals vom Verhältnis 1:1 ab, d.h. tritt der Signalzustand "High", über eine hinreichend lange Zeit gesehen, länger (bzw. kürzer) als der Signalzustand "Low" auf, so kommt es zu einer entsprechenden Änderung des Ausgangssignals der Tiefpaßschaltung TP und damit auch des über den Regelverstärker RV dem Steuereingang k des Korrekturglieds K zugeführten Steuersignals, auf Grund dessen im Korrekturglied K die ansteigenden Digitalsignal-Flanken eine erhöhte (bzw. verringerte) Laufzeit und die abfallenden Digitalsignal-Flanken eine verringerte (bzw. erhöhte) Laufzeit erfahren. Für das am Signalweg-Ausgang a auftretende Breitband-Digitalsignal kann damit die Abweichung des Tastverhältnisses vom Wert 1:1 weitgehend beseitigt werden.

Wie Korrekturglied K und Begrenzerschaltung BS im einzelnen realisiert sein können, wird aus dem in FIG 2 gezeigten weiteren Ausführungsbeispiel einer Schaltungsanordnung zur Zeitregeneration von Breitband-Digitalsignalen gemäß der Erfindung ersichtlich:

Gemäß FIG 2 ist das Korrekturglied K mit einer Schwellwertschaltung KS mit von der Steuerschaltung S gesteuerter Schaltschwelle gebildet, und zwar mit einem in den Digitalsignalweg e - a eingefügten Schalttransistor Tk in Gateschaltung, zu dessen Gate-Elektrode die Steuerschaltung S führt und der ausgangsseitig über einen Lasttransistor Tl an einer Speisepotentialquelle $U_{DD}$ (beispielsweise + 5V) liegt; dabei ist im Ausführungsbeispiel gemäß FIG 2 der Schalttransistor Tk ein n-Kanal-Anreicherungs-Feldeffekttransistor und der - zusammen mit der Speisepotentialquelle $U_{DD}$ eine Stromquellenschaltung bildende - Lasttransistor Tl ein p-Kanal-Anreicherungs-Feldeffekttransistor.

Die Begrenzerschaltung BS ist mit einer zwei Transistoren Tpb, Tnb aufweisenden C-MOS-Inverterschaltung gebildet; wie in FIG 2 weiter angedeutet ist, kann die Tiefpaßschaltung TP mit einem einfachen RC-Glied gebildet sein. Nachdem gemäß FIG 2 die Tiefpaßschaltung TP an den Ausgang $\bar{a}$ der Inverterschaltung Tpb, Tnb angeschlossen ist, wird der dort bewirkten Digitalsignal-Invertierung Rechnung getragen, und zwar dadurch, daß gemäß FIG 2 die Eingänge des - wiederum zwischen Tiefpaßschaltung TP und Korrekturglied-Steuereingang k eingefügten - Regelverstärkers RV im Vergleich zu den in FIG 1 dargestellten Verhältnissen miteinander vertauscht sind.

Im übrigen ist im Ausführungsbeispiel gemäß FIG 2 die Steuerschaltung S in Abweichung von den in FIG 1 dargestellten Verhältnissen des Korrekturglieds K im Digitalsignalweg e-a nachgeschaltet; an Stelle der Steueranordnung gemäß FIG 1 erhält man so gemäß FIG 2 eine Regelanordnung mit der einer solchen Anordnung immanenten Möglichkeit, durch entsprechende Beschaltung des Regelverstärkers RV Abweichungen des Tastverhältnisses von ihrem Sollwert beliebig genau korrigieren zu können.

In der Zeitregenerationsschaltung gemäß FIG 2 möge am Signalweg-Eingang e und damit am Digitalsignaleingang des Korrekturglied K im Digitalsignalzustand "High" ein Potential von beispielsweise etwa -1 V und im Digitalsignalzustand "Low" ein Potential von beispielsweise etwa -2 V herrschen, wobei aufgrund einer Codierung des Breitband-Digitalsignals in einem gleichstromfreien Code statistisch, d.h. über eine hinreichend lange Zeit gesehen, die beiden Potentialzustände gleich lange auftreten sollten. Am Steuereingang k des Korrekturglieds K und damit an der Gate-Elektrode des Schalttransistors Tk der Schwellwertschaltung KS möge dabei von der Steuerschaltung S her ein Steuerpotential von beispielsweise etwa +0,4 V anliegen, wobei die Schaltschwelle des mit dem Lasttransistor Tl verbundenen Schalttransistors Tk um eine Schwellenspannung von beispielsweise etwa -1,8 V darunter liegen möge.

Beim Signalzustand "High" ist dann in der Schwellwertschaltung KS der Schalttransistor Tk nichtleitend, und am Eingang der nachfolgenden Begrenzerschaltung BS, deren Schaltschwelle etwa bei +1 V liegen möge, bildet sich ein Potential von im Beispiel etwa +3,3 V aus, aufgrund dessen der p-Kanal-Transistor Tpb der C-MOS-Inverterschaltung nichtleitend (oder allenfalls sehr schwach leitend) und der n-Kanal-Transistor Tnb (gut) leitend ist; beim Digitalsignalzustand "Low" ist in der Schwellwertschaltung KS der Schalttransistor Tk leitend, und am Eingang der nachfolgenden Begrenzerschaltung BS bildet sich ein Potential von im Beispiel etwa -1,2 V aus, aufgrund dessen der p-Kanal-Transistor Tpb der C-MOS-Inverterschaltung leitend und der n-Kanal-Transistor Tnb nichtleitend ist.

Über die Tiefpaßschaltung TP gelangt ein dem zeitlichen Mittelwert des am Begrenzerausgang $\bar{a}$ auftretenden Digitalsignals zu dem einen Eingang (-) des Differenzverstärkers RV, dessen anderer Eingang (+) mit einem Referenzsignal r2 beaufschlagt sein möge und von dessen Ausgang bei einem vom Breitband-Digitalsignal eingehaltenen Tastverhältnis 1:1 das erwähnte Steuerpotential von im Beispiel +0,4 V abgegeben werden möge.

Weicht das Tastverhältnis des Breitband-Digitalsignals vom Verhältnis 1:1 ab, d.h. tritt, über eine hinreichend lange Zeit gesehen, am Signalweg-Eingang e der Signalzustand "High" länger (bzw. kürzer) als der Signalzustand "Low" - und demzufolge am Inverterausgang $\bar{a}$ der Signalzustand "Low" länger (bzw. kürzer) als der Signalzustand "High" - auf, so kommt es zu einer entsprechenden Absenkung (bzw. Anhebung) des Ausgangssignals der Tiefpaßschaltung TP und damit zu einer entsprechenden Erhöhung (bzw. Verringerung) der Eingangssignaldifferenz beim Regelverstärker RV; dies bewirkt eine entsprechende Anhebung (bzw. Absenkung) des vom Ausgang des Regelverstärkers RV dem Steuereingang k des Korrekturglieds K zugeführten Potentials um einen Betrag von beispielsweise 0,2 V mit der Folge, daß dementsprechend die Schaltschwelle der C-MOS-Schwellwertschaltung KS angehoben (bzw. herabgesetzt) wird. Die ansteigenden Digitalsignalflanken überschreiten die Schaltschwelle daher später (bzw. früher) und erfahren damit eine erhöhte (bzw. verringerte) Laufzeit, und die abfallenden Digitalsignalflanken unterschreiten die Schaltschwelle früher (bzw. später) und erfahren damit eine verringerte (bzw. erhöhte) Laufzeit. Für das am signalweg-Ausgang ($\bar{a}$ in FIG 2; hier kann ggf. aber auch noch eine weitere Inverterschaltung nachgeschaltet sein, um die in der Begrenzerschaltung BS gemäß FIG 2 bewirkte Invertierung des Breitband-Digitalsignals wieder aufzuheben) auftretende Breitband-Digitalsignal kann so jede Abweichung des Tastverhältnisses vom Sollwert 1:1 beseitigt werden.

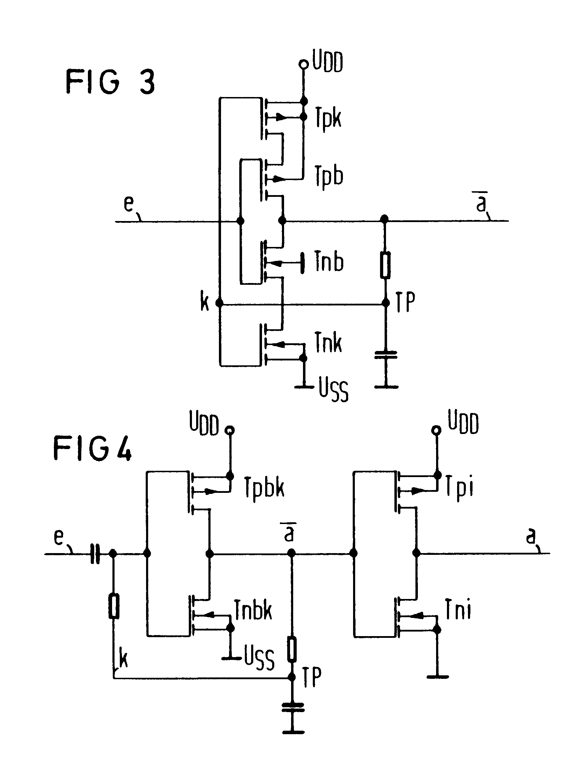

In FIG 3 ist ein Ausführungsbeispiel einer Schaltungsanordnung gemäß der Erfindung dargestellt, in welchem das Korrekturglied wiederum mit einer Schwellwertschaltung mit von einer Steuerschaltung gesteuerter Schaltschwelle gebildet ist und die Steuerschaltung wiederum eine vom Digitalsignal beaufschlagte Begrenzerschaltung und eine ihr nachgeschaltete Tiefpaßschaltung TP aufweist, wobei nunmehr aber Begrenzerschaltung und Korrekturglied im Digitalsignalweg eine einzige Schaltungsstufe bilden. Die Begrenzerschaltung ist wiederum eine in C-MOS-Technik realisierte Inverterschaltung Tpb, Tnb; dabei ist jetzt zwischen den p-Kanal-Transistor Tpb und die zugehörige Speisepotentialquelle $U_{DD}$ ein weiterer p-Kanal-Transistor Tpk eingefügt, und zwischen den n-Kanal-Transistor Tnb und die zugehörige Speisepotentialquelle $U_{SS}$ ist ein weiterer n-Kanal-Transistor Tnk eingefügt. Diese beiden weiteren C-MOS-Transistoren Tpk und Tnk werden an ihren Steuerelektroden von der gemäß FIG 3 wiederum mit einem RC-Glied gebildeten Tiefpaßschaltung TP her gesteuert.

Der Signalweg-Ausgang ist in FIG 3 mit $\bar{a}$ bezeichnet, womit der in der Inverterschaltung Tpb, Tnb bewirkten Invertierung des zeitregenerierten Breitband-Digitalsignals Rechnung getragen wird; ggf. kann hier aber auch noch eine weitere Inverterschaltung eingefügt sein, um die Invertierung des Breitband-Digitalsignals wieder aufzuheben.

Weicht das Tastverhältnis des am Signalweg-Eingang e auftretenden Breitband-Digitalsignals vom Verhältnis 1:1 ab, d.h. tritt, über eine hinreichend lange Zeit gesehen, der Signalzustand "High" länger (bzw. kürzer) als der Signalzustand "Low" auf, so kommt es zu einer entsprechenden Absenkung (bzw. Anhebung) des Ausgangssignals der Tiefpaßschaltung TP und damit auch des über den Steuereingang k den erwähnten beiden weiteren C-MOS-Transistoren Tpk und Tnk zugeführten Steuerpotentials, aufgrund deren im p-Kanal-Transistor Tpk die Kanalbildung erleichtert (bzw. erschwert) und im n-Kanal-Transistor Tnk die Kanalbildung erschwert (bzw. erleichtert) wird mit der Folge, daß dementsprechend die Schaltschwelle der C-MOS-Inverterschaltung Tpb, Tnb angehoben (bzw. herabgesetzt) wird. Die ansteigenden Digitalsignalflanken überschreiten die Schaltschwelle daher später (bzw. früher) und erfahren damit eine erhöhte (verringerte) Laufzeit, und die abfallenden Digitalsignalflanken unterschreiten die Schaltschwelle früher (bzw. später) und erfahren damit eine verringerte (bzw. erhöhte) Laufzeit.

In FIG 4 ist ein weiteres Ausführungsbeispiel einer Schaltungsanordnung zur Zeitregeneration gemäß der Erfindung mit im Digitalsignalweg e - a eine einzige Schaltungsstufe bildender Korrektur- und Begrenzerschaltung dargestellt. Gemäß FIG 4 wird eine in den Signalweg e - a eingefügte C-MOS-Inverterschaltung Tpbk, Tnbk eingangsseitig kapazitiv mit dem am Signalweg-Eingang e zugeführten, zeitlich zu regenerierenden Breitband-Digitalsignals beaufschlagt; zugleich wird der Invertereingang galvanisch mit einer Schaltschwellen-Steuerspannung von einer - gemäß FIG 4 mit einem RC-Glied gebildeten - Tiefpaßschaltung TP her beaufschlagt, wobei die Tiefpaßschaltung TP ihrerseits mit dem invertierten, zeitregenerierten Digitalsignal beaufschlagt ist. Hinter dem dazu mit dem Eingang der Tiefpaßschaltung TP direkt verbundenen Ausgang $\bar{a}$ der C-MOS-Inverterschaltung Tpbk, Tnbk ist in den eigentlichen Digitalsignalweg e - a noch eine weitere C-MOS-Inverterschaltung Tpi, Tni eingefügt, um die in der Korrektur- und Begrenzerschaltung Tpbk, Tnbk bewirkte Invertierung des Breitband-Digitalsignals wieder aufzuheben. Eine solche zusätzliche Inverterschaltung (Tpi, Tni in FIG 4) kann, wie oben bereits angedeutet wurde, auch bei den Schaltungsanordnungen gemäß FIG 2 und FIG 3 vorgesehen sein, ohne daß dies in FIG 2 und FIG 3 im einzelnen dargestellt ist.

Weicht in der Schaltungsanordnung gemäß FIG 4 das Tastverhältnis des am Signalweg-Eingang e auftretenden Breitband-Digitalsignals vom Verhältnis 1:1 ab und tritt, über eine hinreichend lange Zeit gesehen, der Signalzustand "High" länger (bzw. kürzer) als der Signalzustand "Low" auf, so kommt es zu einer entsprechenden Absenkung (bzw. Anhebung) des Ausgangssignals der Tiefpaßschaltung TP und damit auch der über den Steuereingang k der Inverterschaltung Tpbk,Tnbk galvanisch zugeführten Vorspannung mit der Folge einer entsprechenden Verlagerung des an den Steuerelektroden der beiden Transistoren Tpbk und Tnbk wirksamen, zeitlich zu regenerierenden Breitband-Digitalsignals. Die ansteigenden Digitalsignalflanken überschreiten daher die Schaltschwelle später (bzw. früher) und erfahren damit eine erhöhte (bzw. verringerte) Laufzeit, und die abfallenden Digitalsignalflanken unterschreiten die Schaltschwelle früher (bzw.später) und erfahren damit eine verringerte (bzw. erhöhte) Laufzeit.

In der Schaltungsanordnung gemäß FIG 4 wird - ebenso wie in der Schaltungsanordnung gemäß FIG 3 - das von der Tiefpaßschaltung TP ausgangsseitig abgegebene Signal direkt, d.h. unter Verzicht auf einen Regelverstärker, dem Steuereingang k zugeführt. Der Verzicht auf einen Regelverstärker bedeutet, daß nur eine P-Regelcharakteristik möglich ist, deren Wirkung zugunsten der Stabilität des Regelkreises schwach dimensioniert sein sollte.

## Patentansprüche

1. Zur Zeitregeneration von Digitalsignalen geeignete Schaltungsanordnung mit einer Korrekturschaltung und einer zugehörigen, eine Tiefpaßschaltung enthaltenden Steuerschaltung, wobei in den Signalweg (e-a) ein einen Digitalsignaleingang und einen Steuereingang (k) aufweisendes Korrekturglied (K), in dem das Digitalsignal nach Maßgabe der im Digitalsignal auftretenden Gleichstromkomponente an seinen Signalflanken des jeweils einen Vorzeichens eine erhöhte Laufzeit und zugleich an seinen Signalflanken des jeweils anderen Vorzeichens eine verringerte Laufzeit erfahren kann, eingefügt ist, zu dessen Steuereingang (k) eine eine entsprechende Gleichstromkomponente ermittelnde Steuerschaltung (S) mit einer vom Digitalsignal beaufschlagten Begrenzerschaltung (BS) und einer ihr nachgeschalteten Tiefpaßschaltung (TP) führt,
**dadurch gekennzeichnet,**
daß zur Zeitregeneration von in einem gleichstromfreien Code codierten Breitband-Digitalsignalen in Breitband-Digitalsignal-Vermittlungs- u./o. Übertragungssystemen in dem Korrekturglied (K) das Digitalsignal nach Maßgabe jeder im Digitalsignal auftretenden Gleichstromkomponente an seinen Signalflanken des jeweils einen Vorzeichens eine erhöhte Laufzeit und zugleich an seinen Signalflanken des jeweils anderen Vorzeichens eine verringerte Laufzeit erfährt,
wobei das Korrekturglied (K) mit einer eine von der Steuerschaltung (S) gesteuerte Schaltschwelle aufweisenden Schwellwertschaltung (KS) gebildet ist, in der in den Digitalsignalweg (e - a) ein mit einem Lasttransistor (Tl) verbundener Schalttransistor (Tk) in Gateschaltung eingefügt ist, zu dessen Gate-Elektrode die Steuerschaltung (S) führt.

2. Schaltungsanordnung nach Anspruch 1,
**dadurch gekennzeichnet,**
daß die Begrenzerschaltung (BS) dem Korrekturglied (K) im Digitalsignalweg (e - a) vorgeschaltet ist.

3. Schaltungsanordnung nach Anspruch 1,
**dadurch gekennzeichnet,**
daß die Begrenzerschaltung (BS) dem Korrekturglied (K) im Digitalsignalweg (e - a) nachgeschaltet ist.

4. Schaltungsanordnung nach einem der Ansprüche 1 bis 3,
**dadurch gekennzeichnet,**
daß die Tiefpaßschaltung (TP) mit einem RC-Glied gebildet ist.

5. Schaltungsanordnung nach einem der Ansprüche 1 bis 4,
**dadurch gekennzeichnet,**
daß die Tiefpaßschaltung (TP) über einen Regelverstärker (RV) mit dem Steuereingang (k) des Korrekturglieds (K) verbunden ist.

**6.** Schaltungsanordnung nach Anspruch 5,
**dadurch gekennzeichnet,**
daß der Regelverstärker ein an einem Referenzeingang mit einem Referenzsignal (r) beaufschlagter Differenzverstärker (RV) ist.

**7.** Zur Zeitregeneration von Digitalsignalen geeignete Schaltungsanordnung mit einer Korrekturschaltung und einer zugehörigen, eine Tiefpaßschaltung enthaltenden Steuerschaltung, wobei in den Signalweg (e-a) ein einen Digitalsignaleingang und einen Steuereingang (k) aufweisendes Korrekturglied (K), in dem das Digitalsignal nach Maßgabe der im Digitalsignal auftretenden Gleichstromkomponente an seinen Signalflanken des jeweils einen Vorzeichens eine erhöhte Laufzeit und zugleich an seinen Signalflanken des jeweils anderen Vorzeichens eine verringerte Laufzeit erfahren kann, eingefügt ist, zu dessen Steuereingang (k) eine eine entsprechende Gleichstromkomponente ermittelnde Steuerschaltung (S) mit einer vom Digitalsignal beaufschlagten Begrenzerschaltung (BS) und einer ihr nachgeschalteten Tiefpaßschaltung (TP) führt,
**dadurch gekennzeichnet,**
daß zur Zeitregeneration von in einem gleichstromfreien Code codierten Breitband-Digitalsignalen in Breitband-Digitalsignal-Vermittlungs-u./o. Übertragungssystemen in dem Korrekturglied (K) das Digitalsignal nach Maßgabe jeder im Digitalsignal auftretenden Gleichstromkomponente an seinen Signalflanken des jeweils einen Vorzeichens eine erhöhte Laufzeit und zugleich an seinen Signalflanken des jeweils anderen Vorzeichens eine verringerte Laufzeit erfährt,
wobei die mit einer Inverterschaltung (Tpb, Tnb) gebildete Begrenzerschaltung (BS) und das Korrekturglied (K) im Digitalsignalweg (e - a) eine einzige Schaltungsstufe bilden, in der bei einer in C-MOS-Technik realisierten Inverterschaltung (Tpb, Tnb) zwischen den MOS-Transistor (Tpb) des einen Kanaltyps und die zugehörige Speisepotentialquelle ($U_{DD}$) ein an seiner Steuerelektrode von der Tiefpaßschaltung (TP) her gesteuerter weiterer MOS-Transistor (Tpk) ebenfalls des einen Kanaltyps und zwischen den MOS-Transistor (Tnb) des anderen Kanaltyps und die zugehörige Speisepotentialquelle ($U_{SS}$) ein an seiner Steuerelektrode von der Tiefpaßschaltung (TP) her gesteuerter weiterer MOS-Transistor (Tnk) ebenfalls des anderen Kanaltyps eingefügt ist.

**8.** Schaltungsanordnung nach Anspruch 7,
**dadurch gekennzeichnet,**
daß der Inverterausgang ($\bar{a}$) über ein RC-Glied (TP) mit den Steuerelektroden der beiden weiteren Transistoren (Tpk, Tnk) verbunden ist.

**9.** Zur Zeitregeneration von Digitalsignalen geeignete Schaltungsanordnung mit einer Korrekturschaltung und einer zugehörigen, eine Tiefpaßschaltung enthaltenden Steuerschaltung, wobei in den Signalweg (e-a) ein einen Digitalsignaleingang und einen Steuereingang (k) aufweisendes Korrekturglied (K), in dem das Digitalsignal nach Maßgabe der im Digitalsignal auftretenden Gleichstromkomponente an seinen Signalflanken des jeweils einen Vorzeichens eine erhöhte Laufzeit und zugleich an seinen Signalflanken des jeweils anderen Vorzeichens eine verringerte Laufzeit erfahren kann, eingefügt ist, zu dessen Steuereingang (k) eine eine entsprechende Gleichstromkomponente ermittelnde Steuerschaltung (S) mit einer vom Digitalsignal beaufschlagten Begrenzerschaltung (BS) und einer ihr nachgeschalteten Tiefpaßschaltung (TP) führt,
**dadurch gekennzeichnet,**
daß zur Zeitregeneration von in einem gleichstromfreien Code codierten Breitband-Digitalsignalen in Breitband-Digitalsignal-Vermittlungs-u./o. Übertragungssystemen in dem Korrekturglied (K) das Digitalsignal nach Maßgabe jeder im Digitalsignal auftretenden Gleichstromkomponente an seinen Signalflanken des jeweils einen Vorzeichens eine erhöhte Laufzeit und zugleich an seinen Signalflanken des jeweils anderen Vorzeichens eine verringerte Laufzeit erfährt,
wobei die mit einer Inverterschaltung (Tpb, Tnb) gebildete Begrenzerschaltung (BS) und das Korrekturglied (K) im Digitalsignalweg (e - a) eine einzige Schaltungsstufe bilden, in der eine in den Signalweg (e -a) eingefügte Inverterschaltung (Tpbk, Tnbk) eingangsseitig kapazitiv mit dem zugeführten, zeitlich zu regenerierenden Digitalsignal und zugleich galvanisch mit einer Schaltschwellen-Steuerspannung von einer Tiefpaßschaltung (TP) her beaufschlagt wird, die ihrerseits mit dem invertierten, zeitregenerierten Digitalsignal beaufschlagt ist.

**Claims**

**1.** Circuit arrangement suitable for the time regeneration of digital signals, having a correction circuit and an associated control circuit containing a low-pass filter circuit, a correction element (K) having a digital signal input and a control input (k) being inserted in the signal path (e-a), in which correction element the digital signal can experience an increased propagation time at its signal edges of one sign in each case and simultaneously a decreased propagation time at its signal edges of the respective other sign in accordance with the direct current component occurring in the digital signal, connected to the control input (k) of which correction element is a control circuit (S) which determines a corresponding direct current component and has a limiter circuit (BS) to which the digital signal is applied and a low-pass filter circuit (TP) connected downstream thereof, characterised in that, for the time regeneration of broadband digital signals coded in a direct-current-free code in broadband digital signal exchanges and/or transmission systems, in the correction element (K) the digital signal experiences an increased propagation time at its signal edges of one sign in each case and simultaneously a decreased propagation time at its signal edges of the respective other sign in accordance with each direct current component occurring in the digital signal, the correction element (K) being formed by a threshold circuit (KS) having a switching threshold controlled by the control circuit (S), in which threshold circuit a switching transistor (Tk) connected to a load transistor (Tl) is inserted in the digital signal path (e - a) in gate circuitry, to the gate electrode of which the control circuit (S) is connected.

2. Circuit arrangement according to Claim 1, characterised in that the limiter circuit (BS) is connected upstream of the correction element (K) in the digital signal path (e - a).

3. Circuit arrangement according to Claim 1, characterised in that the limiter circuit (BS) is connected downstream of the correction element (K) in the digital signal path (e - a).

4. Circuit arrangement according to one of Claims 1 to 3, characterised in that the low-pass filter circuit (TP) is formed by an RC element.

5. Circuit arrangement according to one of Claims 1 to 4, characterised in that the low-pass filter circuit (TP) is connected to the control input (k) of the correction element (K) via a control amplifier (RV).

6. Circuit arrangement according to Claim 5, characterised in that the control amplifier is a differential amplifier (RV) to which a reference signal (r) is applied at a reference input.

7. Circuit arrangement suitable for the time regeneration of digital signals, having a correction circuit and an associated control circuit containing a low-pass filter circuit, a correction element (K) having a digital signal input and a control input (k) being inserted in the signal path (e-a), in which correction element the digital signal can experience an increased propagation time at its signal edges of one sign in each case and simultaneously a decreased propagation time at its signal edges of the respective other sign in accordance with the direct current component occurring in the digital signal, connected to the control input (k) of which correction element is a control circuit (S) which determines a corresponding direct current component and has a limiter circuit (BS) to which the digital signal is applied and a low-pass filter circuit (TP) connected downstream thereof, characterised in that, for the time regeneration of broadband digital signals coded in a direct-current-free code in broadband digital signal exchanges and/or transmission systems, in the correction element (K) the digital signal experiences an increased propagation time at its signal edges of one sign in each case and simultaneously a decreased propagation time at its signal edges of the respective other sign in accordance with each direct current component occurring in the digital signal, the limiter circuit (BS) formed by an inverter circuit (Tpb, Tnb) and the correction element (K) forming in the digital signal path (e - a) a single switching stage, in which, in the case of an inverter circuit (Tpb, Tnb) realised in CMOS technology, a further MOS transistor (Tpk), likewise of the one channel type, which is controlled at its control electrode by the low-pass filter circuit (TP), is inserted between the MOS transistor (Tpb) of the one channel type and the associated feed potential source ($U_{DD}$), and a further MOS transistor (Tnk), likewise of the other channel type, which is controlled at its control electrode by the low-pass filter circuit (TP), is inserted between the MOS transistor (Tnb) of the other channel type and the associated feed potential source ($U_{SS}$).

8. Circuit arrangement according to Claim 7, characterised in that the inverter output ($\bar{a}$) is connected to the control electrodes of the two further transistors (Tpk, Tnk) via an RC element (TP).

9. Circuit arrangement suitable for the time regeneration of digital signals, having a correction circuit and an associated control circuit containing a low-pass filter circuit, a correction element (K) having a digital signal input and a control input (k) being inserted in the signal path (e-a), in which correction element the digital signal can experience an increased propagation time at its signal edges of one sign in each case and simultaneously a decreased propagation time at its signal edges of the respective other sign in accordance with the direct current component occurring in the digital signal, connected to the control input (k) of which correction element is a control circuit (S) which determines a corresponding direct current component and has a limiter circuit (BS) to which the digital signal is applied and a low-pass filter circuit (TP) connected downstream thereof, characterised in that, for the time regeneration of broadband digital signals coded in a direct-current-free code in broadband digital signal exchanges and/or transmission systems, in the correction element (K) the digital signal experiences an increased propagation time at its signal edges of one sign in each case and simultaneously a decreased propagation time at its signal edges of the respective other sign in accordance with each direct current component occurring in the digital signal, the limiter circuit (BS) formed by an inverter circuit (Tpb, Tnb) and the correction element (K) forming in the digital signal path (e - a) a single switching stage, in which the supplied digital signal that is to undergo time regeneration is capacitively applied at the input side to an inverter circuit (Tpbk, Tnbk) inserted in the signal path (e - a), and simultaneously a switching threshold control voltage is applied electrically by a low-pass filter circuit (TP), to which the inverted, time-regenerated digital signal is applied in turn.

**Revendications**

1. Montage convenant pour la régénération temporelle de signaux numériques, comportant un circuit de correction et un circuit de commande associé contenant un circuit formant filtre passe-bas, et dans lequel dans la voie (e-a) de transmission du signal est inséré un circuit de correction (K), qui possède une entrée du signal numérique et une entrée de commande (k) et dans lequel le signal numérique peut présenter un temps de propagation accru au niveau de ses flancs possédant respectivement un premier signe, en fonction de la composante de courant continu apparaissant dans le signal numérique, et simultanément un temps de propagation réduit au niveau de ses flancs possédant respectivement l'autre signe, et à l'entrée (k) de commande duquel est raccordé un circuit de commande (S) qui détermine une composante correspondante du courant continu et comporte un circuit limiteur (BS) chargé par le circuit numérique et un circuit formant filtre passe-bas (TP) branché en aval de ce circuit limiteur, caractérisé par le fait que pour la régénération temporelle de signaux numériques à large bande codés selon un code sans courant continu, dans des systèmes de commutation et/ou de transmission numérique à large bande, dans le circuit de correction (K), le signal numérique présente un temps de transit accru au niveau de ses flancs possédant respectivement un premier signe, en fonction de chaque composante de courant continu apparaissant dans le circuit numérique, et présente simultanément un temps de propagation réduit au niveau de ses flancs possédant respectivement l'autre signe, le circuit de correction (K) étant formé par un circuit à valeur de seuil (KS) possédant un seuil de commutation commandé par le circuit de commande (S) et dans lequel, dans la voie (e-a) de transmission du signal numérique est inséré un transistor de commutation (Tk) qui est raccordé à un transistor de charge (T1) et est branché selon un montage en grille commune et à l'électrode de grille duquel est raccordé le circuit de commande (S).

2. Montage suivant la revendication 1, caractérisé par le fait que le circuit limiteur (BS) est branché en amont du circuit de correction (K) dans la voie (e-a) de transmission du signal numérique.

3. Montage suivant la revendication 1, caractérisé par le fait que le circuit limiteur (BS) est branché en aval du circuit de correction (K) dans la voie (e-a) de transmission du signal numérique.

4. Montage suivant l'une des revendications 1 à 3, caractérisé par le fait que le circuit formant filtre passebas (TP) est formé par un circuit RC.

5. Montage suivant l'une des revendications 1 à 4, caractérisé par le fait que le circuit formant filtre passebas (TP) est raccordé au moyen d'un amplificateur de réglage (RV) à l'entrée de commande (k) du circuit de correction (K).

6. Montage suivant la revendication 5, caractérisé par le fait que l'amplificateur de réglage est un amplificateur différentiel (RV) chargé, à son entrée de référence, par un signal de référence (k).

7. Montage convenant pour la régénération temporelle de signaux numériques, comportant un circuit de correction et un circuit de commande associé contenant un circuit formant filtre passe-bas, et dans lequel dans la voie (e-a) de transmission du signal est inséré un circuit de correction (K), qui possède une entrée du signal numérique et une entrée de commande (k) et dans lequel le signal numérique peut présenter un temps de propagation accru au niveau de ses flancs possédant respectivement un premier signe, en fonction de la composante de courant continu apparaissant dans le signal numérique, et simultanément un temps de propagation réduit au niveau de ses flancs possédant respectivement l'autre signe, et à l'entrée (k) de commande duquel est raccordé un circuit de commande (S) qui détermine une composante correspondante du courant continu et comporte un circuit limiteur (BS) chargé par le circuit numérique et un circuit formant filtre passe-bas (TP) branché en aval de ce circuit limiteur,
caractérisé par le fait
que pour la régénération temporelle de signaux numériques à large bande codés selon un code sans courant continu, dans des systèmes de commutation et/ou de transmission numérique à large bande, dans le circuit de correction (K), le signal numérique présente un temps de transit accru au niveau de ses flancs possédant respectivement un premier signe, en fonction de chaque composante de courant continu apparaissant dans le circuit numérique, et présente simultanément un temps de propagation réduit au niveau de ses flancs possédant respectivement l'autre signe,
le circuit limiteur (BS) formé par un circuit inverseur (Tpb, Tnb), et le circuit de correction (K) formant, dans la voie (e-a) de transmission du signal numérique, constituant un seul étage de circuit, dans lequel, dans le cas d'un circuit inverseur (Tpb, Tnb) réalisé selon la technique C-MOS, entre le transistor MOS (Tpb) possédant un premier type de canal et la source associée de potentiel d'alimentation ($U_{DD}$) est inséré un autre transistor MOS (Tpk) possédant également le premier type de canal et commandé, au niveau de son électrode de commande, par le circuit formant filtre passe-bas (TP), et entre le transistor MOS (Tnb) disposé dans l'autre type de canal et la source associée du potentiel d'alimentation ($U_{SS}$) est inséré un autre transistor MOS (Tnk) possédant également l'autre type de canal et commandé, au niveau de son électrode de commande, par le circuit formant filtre passe-bas (TP).

8.  Montage suivant la revendication 7, caractérisé par le fait que la sortie ($\overline{a}$) de l'inverseur est raccordée par l'intermédiaire d'un circuit RC (TP) aux électrodes de commande des deux autres transistors (Tpk, Tnk).

9.  Montage convenant pour la régénération temporelle de signaux numériques, comportant un circuit de correction et un circuit de commande associé contenant un circuit formant filtre passe-bas, et dans lequel dans la voie (e-a) de transmission du signal est inséré un circuit de correction (K), qui possède une entrée du signal numérique et une entrée de commande (k) et dans lequel le signal numérique peut présenter un temps de propagation accru au niveau de ses flancs possédant respectivement un premier signe, en fonction de la composante de courant continu apparaissant dans le signal numérique, et simultanément un temps de propagation réduit au niveau de ses flancs possédant respectivement l'autre signe, et à l'entrée (k) de commande duquel est raccordé un circuit de commande (S) qui détermine une composante correspondante du courant continu et comporte un circuit limiteur (BS) chargé par le circuit numérique et un circuit formant filtre passe-bas (TP) branché en aval de ce circuit limiteur,
caractérisé par le fait
que pour la régénération temporelle de signaux numériques à large bande codés selon un code sans courant continu, dans des systèmes de commutation et/ou de transmission numérique à large bande, dans le circuit de correction (K), le signal numérique présente un temps de transit accru au niveau de ses flancs possédant respectivement un premier signe, en fonction de chaque composante de courant continu apparaissant dans le circuit numérique, et présente simultanément un temps de propagation réduit au niveau de ses flancs possédant respectivement l'autre signe,
le circuit limiteur (BS), formé par un circuit inverseur (Tpb, Tnb), et le circuit de correction (K) constituant, dans la voie (e-a) de transmission du signal numérique, un seul étage de circuit, dans lequel un circuit inverseur (Tpbk, Tnbk) inséré dans la voie (e-a) de transmission du signal est chargé capacitivement sur son côté entrée, par le signal numérique envoyé, qui doit être régénéré dans le temps, et est chargé simultanément galvaniquement par la tension de commande de seuil de commutation délivrée par un circuit formant filtre passe-bas (TP) qui, pour sa part, est chargé par le signal numérique inversé, régénéré dans le temps.

# FIG 1

# FIG 2

EP 0 239 844 B1

FIG 3

FIG 4